# EUROPEAN PATENT APPLICATION

(11) **EP 0 772 245 A2**
(43) Date of publication of application: **07.05.1997**
(21) Application number: 96307889.4
(22) Date of filing: 31.10.1996
(51) Int. Cl.: H01L 29/78, G02F 1/136

(54) **Field effect semiconductor device and liquid crystal display apparatus**

(30) Priority: 01.11.1995 JP 284924/95; 25.10.1996 JP 283800/96
(71) Applicant: CANON KABUSHIKI KAISHA, Tokyo (JP)
(72) Inventor: Watanabe, Takanori, Shimomaruko, Ohta-ku, Tokyo (JP)
(74) Representative: Beresford, Keith Denis Lewis

(57) **Abstract**

A semiconductor device is provided which comprises impurity diffusion regions for a source region and a drain region, a gate electrode, and a channel region under the gate electrode, and an insulation layer provided at least in a part of periphery of area including the channel region, the drain region, and the source region, wherein at least one of wirings for application of potential to the source region, the drain region, or the gate region passes over the impurity diffusion layer of a higher impurity concentration than the channel region of a conduction type different from the source and drain regions, and the impurity diffusion layer is placed directly underneath a thin portion of the insulation layer. With the constitution, the channel stop layer can be formed in a sufficient depth and impurity conentration in a short time, and the distance between the dense n-layer of the source or the drain and the channel stop layer can be shortened.

## Description

### BACKGROUND OF THE INVENTION

### Field of the Invention

The present invention relates to a semiconductor device and a liquid crystal display apparatus. More particularly, the present invention relates to a semiconductor device which has impurity diffusion regions for a source and a drain, a gate electrode, and a channel region provided under the gate electrode; and to a liquid crystal display apparatus employing the semiconductor device.

### Related Background Art

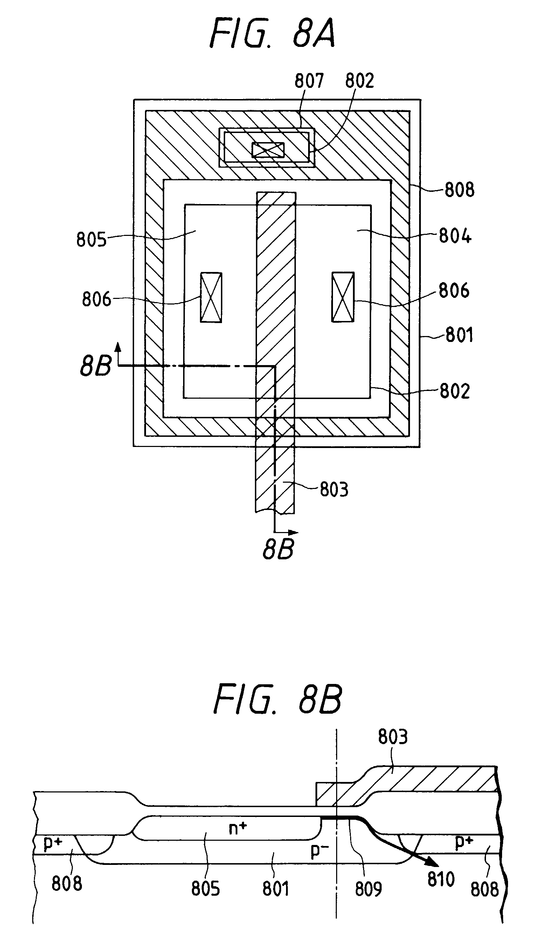

Fig. 8A shows a plan view of a conventional semiconductor device. Fig. 8B is a sectional view of the semiconductor device taken along the bloken line 8B - 8B of Fig. 8A. The broken line in Fig. 8B indicates the bending portion of the cross-section 8B - 8B. An n-type MOS transistor formed on an n-type substrate is explained by reference to Figs. 8A and 8B. A p-well 801 is formed before formation of active region 802 by selective oxidation. The numeral 803 indicates a gate electrode (for example, polysilicon). Dense n-layers 804, 805 for source and drain regions are formed such that the peripheries are defined by the gate electrode and the active region. The n-layers are connected through contacts 806 to metal wirings (not shown in the drawing). In order to fix the potential of the p-well, an active region is provided in the same p-well as the transistor, whereby a dense p-layer 807 is formed and a potential is applied by a contact. Further, a parasitic MOS transistor is turned on in the semiconductor region underneath the selective oxidation film. Thereby, leakage from the source or the drain of the substrate or the adjacent transistor is prevented. Additionally, channel stop layer 808 is formed before formation of the active region to prevent actuation of a parasitic bipolar transistor constituted of the dense n-layers for the source and drain regions, the p-well, and the n-substrate.

However, the constitution shown in Figs. 8A and 8B involves the problems below in the production process. The channel stop layer 808 has to be formed before the selective oxidation, and the ion implantation therefor requires long time for a sufficient implantation depth and a sufficient concentration. Further, dense n-layers 804, 805 and channel stop layer 808 should be separated by interspace to obtain dielectric strength between the source or drain and the well. This interspace is preferably larger than the distance of extension of the depletion layer from the source and drain regions even under practical bias conditions. The required distance makes naturally the transistor larger in size, and prevents increase of the integration degree of the circuit. Further, an inversion region 809 is formed underneath the gate electrode 803 by the influence of the electric field of the gate electrode formed under a bias condition for turning-on of the transistor. At that time, under the birdsbeak in selective oxidation, the electric field of the gate electrode gives influence to cause malfunction of the circuit such as latch-up owing to actuation of the parasitic bipolar transistor 810 around the inversion region 809, the p-well 801, and the n-type substrate.

### SUMMARY OF THE INVENTION

The inventors of the present invention made comprehensive studies to solve the above problems, and have completed the present invention.

The semiconductor device of the present invention comprises first impurity diffusion regions for a source region and a drain region, a gate electrode, and a channel region under the gate electrode, and an insulation layer provided at least in a part of periphery of the area including the area including the channel region, the drain region, and the source region, wherein at least one of wirings for application of potential to the source region, the drain region, or the gate region passes over a second impurity diffusion region of a higher impurity concentration than the channel region of a conduction type different from the source and drain regions, and the second impurity diffusion region is placed directly underneath a thin portion of the insulation layer.

The wiring for application of potential is preferably the wiring for application of potential to the gate electrode.

The wiring for application of the potential to the gate electrode has preferably a width of not more than twice the distance of the lateral diffusion of the impurity of the second impurity diffusion region.

The wiring for application of potential to the gate electrode is preferably made from an electroconductive material different from the material of the gate electrode on the portion where the wiring passes over the second impurity diffusion region.

The second impurity diffusion region may be provided so as to surround the transistor constitution.

The semiconductor device of the present invention is useful for a liquid display apparatus.

The semiconductor device may be used as a transistor which is constituted of repetition of the same pattern of regions, and has circuit for writing or reading signals.

According to the present invention, at least one of wirings for application of potential to the source region, drain region, and gate region is preferably arranged to pass over the second impurity diffusion region having an impurity concentration higher than the channel region in a conduction type different from the gate wiring and drain wiring, therefore, higher circuit integration by size reduction, prevention of actuation of a parasitic bipolar transistor, prevention of current leakage between the source or drain electrode and the substrate and malfunction of the circuit are enabled.

In the semiconductor of the present invention, the depth of the ion implantation can be reduced by forming a channel stop layer in the thin portion of the insulation film for separating the elements. A dense p-layer is employed as the channel stop layer of the n-MOS transistor, and the dense p-layer and the source and drain regions can be formed simultaneously with formation of p-MOS, and vice versa. The thick portion of the insulation layer for the element separation has preferably a thickness ranging from 2000 to 20000 Å, more preferably from 4000 to 10000 Å. The thin portion of the insulation film for the element separation, which is provided immediately above the channel stop layer, can be formed simultaneously with the gate oxidation film of the transistor, and has preferably a thickness ranging from 50 to 2000 Å, more preferably from 100 to 1000 Å.

According to the present invention, a specific process is not required for providing a channel stop layer, which simplifies the production process. Further, a dense impurity region of conduction type different from the source and the drain is provided underneath the transistor wiring, which enables size reduction, prevention of malfunction of the circuit, and operation at a high voltage of the semiconductor device. Thereby, a semiconductor device can be produced at a low cost with a high integration degree by a simplified production process. By use of the semiconductor device, a liquid crystal display apparatus is produced at a low cost with high fineness.

### BRIEF DESCRIPTION OF THE DRAWINGS

Fig. 1A and Fig. 1B are a plan view and a sectional view respectively of a first embodiment of the semiconductor device of the present invention.

Fig. 2A and Fig. 2B are a plan view and a sectional view respectively of a second embodiment of the semiconductor device of the present invention.

Fig. 3A and Fig. 3B are a plan view and a sectional view respectively of a third embodiment of the semiconductor device of the present invention.

Fig. 4A and Fig. 4B are a plan view and a sectional view respectively of a fourth embodiment of the semiconductor device of the present invention.

Fig. 5 is a drawing for explaining a fifth embodiment of the semiconductor device of the present invention.

Fig. 6 is a drawing for explaining a sixth embodiment of the semiconductor device of the present invention.

Fig. 7 is a sectional view of a semiconductor device of a seventh embodiment of the semiconductor device of the present invention.

Fig. 8A and Fig. 8B are a plan view and a sectional view respectively of a conventional semiconductor device.

### DESCRIPTION OF THE PREFERRED EMBODIMENTS

The embodiments of the present invention is described below by reference to drawings.

### First Embodiment

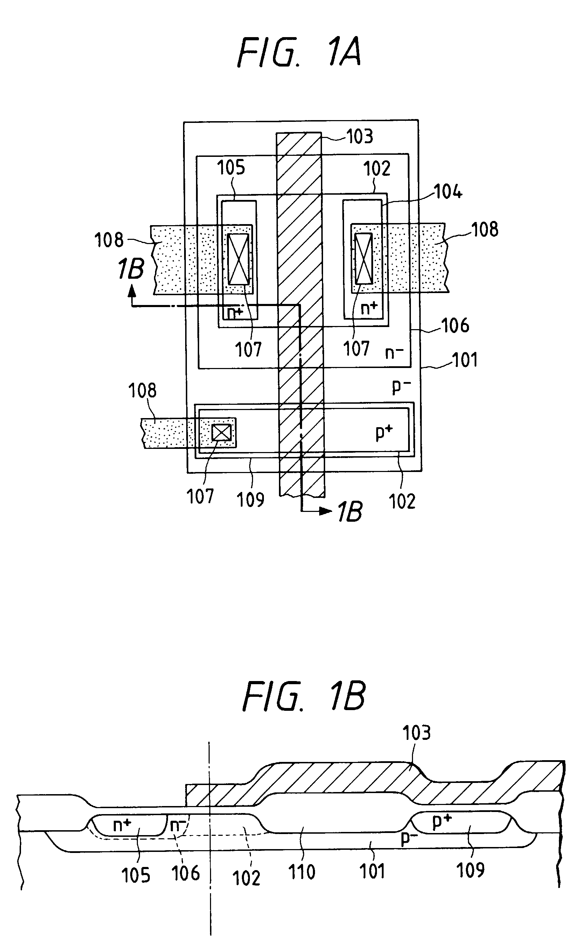

Fig. 1A is a plan view of the first embodiment of the semiconductor device of the present invention. Fig. 1B is a sectional view of the semiconductor device taken along the broken line 1B - 1B of Fig. 1A. The broken line in Fig. 1B indicates the bending portion of the cross-section 1B - 1B. In this embodiment, an n-type MOS transistor is formed on an n-type substrate. The numeral 101 indicates a p-well which may be p⁻ or p⁻⁻, and active region 102 is formed in the p-well. The numeral 103 indicates a gate electrode and its wiring, and 104 and 105 indicates respectively a source region and a drain region formed respectively from a dense n-layer. The numeral 106 indicates a mask pattern of a dilute n-layer formed, for improvement of the dielectric strength of the source and the drain, by injection by gate self alignment in a form of a more dilute n-layer on an active region surface except the portion underneath the gate electrode. Source and drain regions 104, 105 are connected through contacts 107 to metal wirings (for example, aluminum wiring) 108. The wiring of the gate electrode passes over a dense p-layer 109. In this embodiment, a well potential is applied to dense p-layer 109 from wiring 108 through contact 107. Thus the dense p-layer serves also to fix the well potential, and enables miniaturization of the transistor. However, the present invention is effective in either case that the contact for fixing the well potential is provided separately or not provided. To obtain the sectional constitution shown in Fig. 1B, the ion implantation for the dense p-layer may be conducted before the formation of the gate electrode. In the case of forming a CMOS construction, the dense p-layer for the well contact, and the source region and the drain region of the p-type MOS transistor may be formed in one and the same step to simplify the production process. In this embodiment, a dilute p-layer is formed by implantation by gate self alignment for dielectric strength improvement to achieve the effect of the present invention without impairing the performance of the transistor.

The effect of the first embodiment of the present invention is described by reference to Fig. 1B. In this embodiment, the step of channel stop formation under the thick insulation layer is not involved, thereby the production process being simplified. Without the channel stop layer under the thick insulation layer in this embodiment, an inversion layer can be formed by the effect of the electric field generated by gate electrode 103 at portion 110 under the selective oxidation film to give a leakage path between the substrate and the adjacent electrode of the transistor. This leakage path can be intercepted completely by dense p-layer 109. The distances between dense p-layer 109 and dense n-layer 105 or dilute n-layer 106 can be shortened to the same level as the channel stop region in consideration of the dielectric strength, and another dense p-region need not be provided separately for fixing the well potential. Therefore, the transistor can be miniaturized advantageously. Although in this embodiment, an n-type MOS transistor is formed on an n-type substrate, the effect of the present invention can naturally be achieved with a p-type MOS transistor formed on a p-substrate, or with a CMOS circuit. This embodiment is effective also in electrical isolation from adjacent transistors in the case where no well formation is required as n-type MOS is formed on a p-substrate.

### Second Embodiment

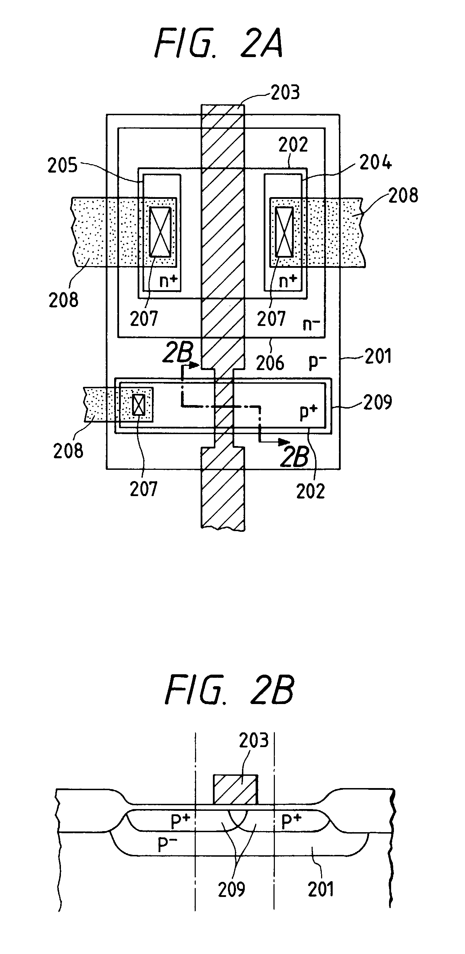

Fig. 2A is a plan view of the second embodiment of the semiconductor device of the present invention. Fig. 2B is a sectional view of the semiconductor device taken along the broken line 2B - 2B of Fig. 2A. In this embodiment, a dense p-layer is formed by ion implantation after a gate electrode has been formed. As shown in Fig. 2A, wiring 203 for the gate electrode is made narrower than the gate breadth at the portion where gate electrode wiring 203 passes over a dense p-region. The structure shown in Fig. 2B can be obtained by reducing the width of the wiring in this portion than twice the lateral diffusion distance of the dense p-layer. Thus the p-layer can be provided by diffusion at the portion directly under the wiring where the ions cannot directly be implanted. Accordingly, the dense p-layer can be formed by ion implantation after the gate electrode has been formed. Therefore, self-alignment-process is available even in the absence of dilute p-layer as described in first embodiment, and in CMOS production process, the formation of a source region and a drain region of a p-MOS transistor and the formation of a dense p-layer 209 for fixing the well potential of an n-MOS transistor can be simultaneously conducted by gate-self-alignment. In this embodiment, the dense p-layer is allowed to diffuse to the portion underneath the electrode wiring. By changing the impurities to the opposite type respectively, a dense n-layer can naturally be formed underneath the gate electrode in one and the same step with the formation of a source region and a drain region of an n-MOS transistor. This embodiment is also effective in the case where a potential is not applied to the dense impurity layer by wiring underneath gate electrode wiring.

### Third Embodiment

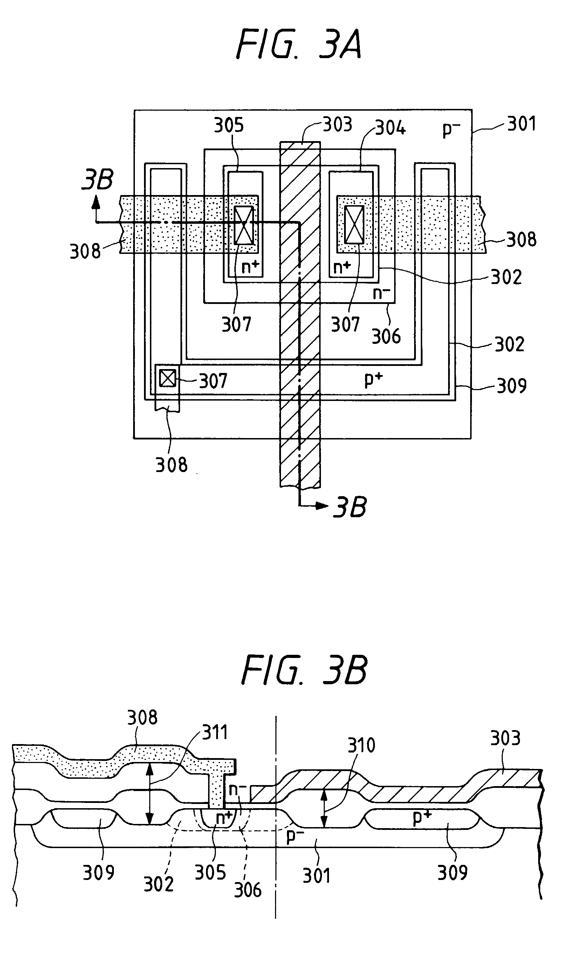

Fig. 3A is a plan view of the third embodiment of the semiconductor device of the present invention. Fig. 3B is a sectional view of the semiconductor device taken along the broken line 3B - 3B of Fig. 3A. As shown in the sectional view of Fig. 3B, the thickness of the insulation layer at the portion to the semiconductor region is changed such that thickness 311 under the metal wiring portion is larger than the thickness 310 of the portion under the gate electrode material wiring portion, thereby the parasitic MOS transistor has a higher threshold value and is less readily turned on. However, in a circuit where a higher voltage is applied to the drain, the parasitic MOS transistor can be turned on at that portion to cause malfunction of the circuit. This problem is solved effectively in this embodiment according to the present invention. In this embodiment, in addition to the aforementioned first embodiment, dense p-layers are provided also under metal wiring 308 for the source and the drain similarly as the gate wiring. Thereby, the function of the parasitic MOS transistor caused by the metal wiring is intercepted, and the malfunction of the circuit is prevented. In Fig. 3A, the dense p-layers under the metal wiring of the source side, under the metal wiring of the drain side, and under the wiring of the gate electrode are in one and the same active region, and potentials are applied thereto respectively. However, the present invention is also effective in the case where the dense p-layers are placed respectively in separate active regions, and potential is not applied.

### Fourth Embodiment

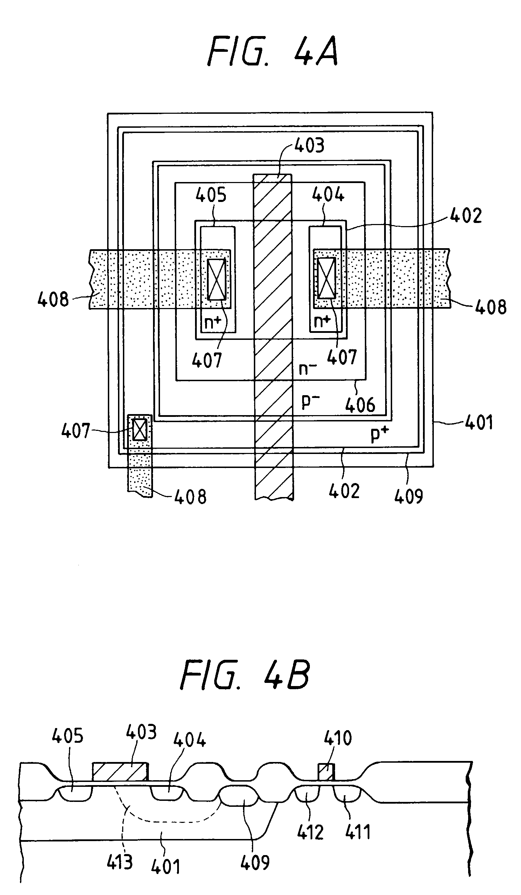

The present invention is made further more effective by providing additionally the dense p-region so as to surround the four sides of the transistor in comparison with the third embodiment where the dense p-regions are provided under wiring portions. Fig. 4A is a plan view of the device of this embodiment. In Fig. 3A, the periphery of the transistor is entirely surrounded by dense p-region 409. With this structure, the width of the depletion layer extending from the drain can be made narrower, whereby separation widths between the adjacent elements can be made smaller. The reason therefor is explained below. Outside the drain 404 of the transistor according to the present invention, dense p-region 409 is provided so as to be separated from source 412 of an adjacent transistor. Thereby, spreading of depletion layer 413 from drain 404 is stopped by dense p-region 409 without reaching the adjacent transistor to prevent malfunction of the circuit. In Figs. 4A and 4B, the concentration at the portion under the gate of the adjacent transistor is the same as that of the substrate. However, the present invention is also effective in the cases where the adjacent transistor is formed with a well of different conduction type from transistor 401, formed with different well of the same conduction type, or formed in the same well.

### Fifth Embodiment

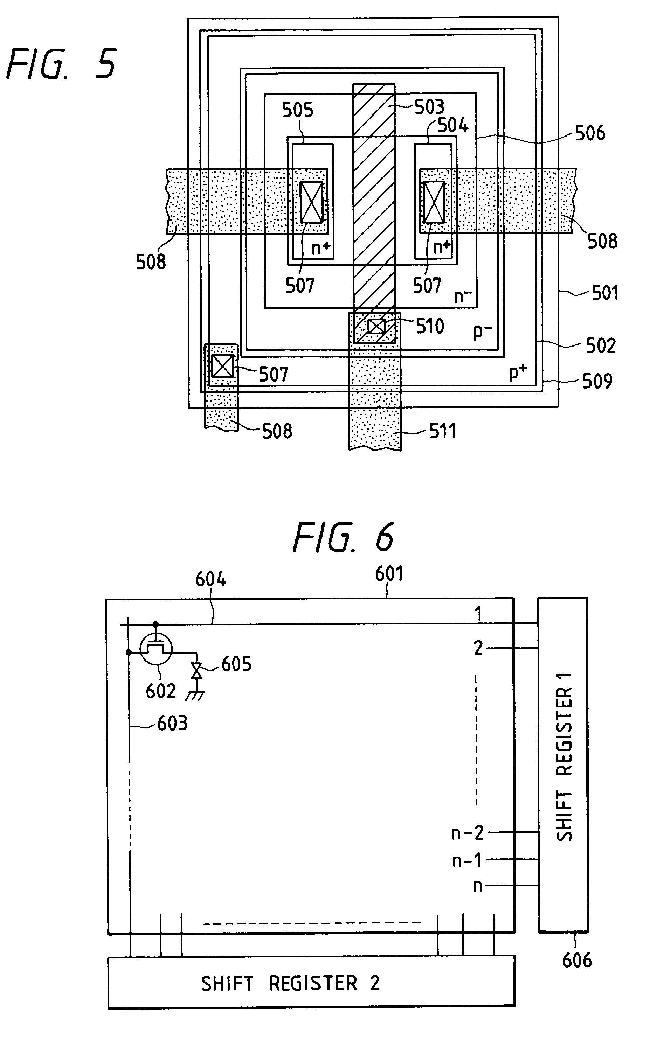

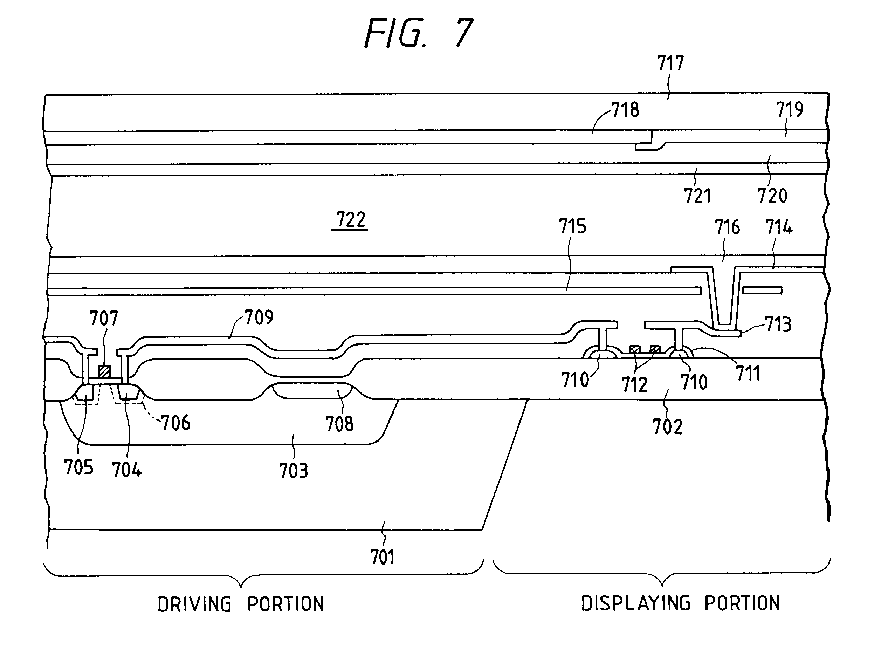

The effect of the present invention is made more remarkable by the structure in which a gate electrode wiring is changed through a contact to a metal wiring and then the metal wiring passes over a dense p-region. In this embodiment, as shown in Fig. 5, gate electrode 503 is connected through contact 510 to metal wiring 511, and then the metal wiring passes over dense region 509. With this structure, the parasitic capacitance between the gate wiring and the dense p-region is reduced, and high speed driving of the circuit is made practicable. Further, the threshold voltage of the parasitic MOS transistor is higher to be less readily turned on with the metal wiring than with the gate electrode, thereby normal driving is practicable to a higher voltage. With the structure of this embodiment, the dense p-region may be formed after formation of the gate electrode by ion implantation similarly as in second embodiment, whereby the effect of second embodiment can also be achieved. Furthermore, in this embodiment, the parasitic resistance of the gate electrode becomes remarkably lower as compared with in the second embodiment to enable higher driving, advantageously.

### Sixth Embodiment

A liquid crystal display is explained which employs the semiconductor devices of the present invention. Fig. 6 illustrates a liquid crystal display apparatus having a switch for each of picture elements. In display portion 601, each of picture elements has switch 602, and picture signals are applied to liquid crystal 605 through signal line 603 with control of gate line 604. To gate lines 604, potential for switch on of the picture elements is applied successively from the first bit to the n-th bit with control by shift resisters 606. When n is increased on the display portion for finer display, or when the chip size is reduced in order to produce a larger number of chips from one wafer, the pitch of pixel array becomes smaller. For example, in a display apparatus having 300,000 picture elements in 1-inch size display portion, the pitch of picture elements is about 30 microns. Then, repetition pitch of shift resister must be smaller than 30 microns. Therefore, reducing space for isolation of the respective transistors is important. Use of the transistors of the first to fifth embodiment of the present invention to a liquid crystal display apparatus enables reduction of the size of the transistor and increase of the numbers of the bits to obtain the liquid crystal display of high fineness. Furthermore, the production of this transistor does not require the step of formation of a channel stop layer, so that a liquid crystal display apparatus can be produced with high throughput at a low cost.

Fig. 7 is a sectional view showing the application of the present invention to a liquid display apparatus. A silicon substrate 701 is, for example, of an n-type, and is bored by etching at the displaying portion to allow light to pass. The numeral 703 indicates a p-well. The transistor in the driving portion is constituted by drain 704, source 705, and dilute n-layer 706 for improving the dielectric strength, and gate 707. Dense p-layer 708 according to the present invention is provided underneath wiring 709. The switch for the picture element is constituted of polysilicon 710 for facilitating the contact, and polysilicon 711 for the channel, and gate 712. Polysilicon 710 may be omitted when the contact is sufficient without it. The drain of the picture element switch is connected through wiring 713 to picture element electrode 714. Picture element electrode 714 can be formed from a transparent electrode by use of ITO. Metal layer 715 is provided for light interception except the opening in the displaying portion, and for light interception of the peripheral circuit. The metal layer can also be used as an electrode for retention of the capacity of the picture element electrode. Polyimide film 716 has been subjected to rubbing treatment. The counter substrate is constituted of glass substrate 717, black matrix 718, color filter 719, flattening film 720, and polyimide 721. Liquid crystal 722 is held between substrate 701 and the counter substrate to form the construction shown in Fig. 7.

The transistor of the peripheral circuit is placed in the p-well in Fig. 7. However, in case of channel region of a MOS transistor is same type as the substrate, the MOS may be constituted without well. The transistor in the driving circuit can be constituted of any of the transistor of the above first to fifth embodiments. The circuit may be constituted of combination thereof. This embodiment has advantages below in addition to the advantages of the above embodiment. Generally, with the liquid crystal display apparatus, the image is observed with transmitted light thrown from the top or from the bottom of the apparatus, or with projected light by means of a projector. On irradiation, photocarriers are produced to increase the leakage current at the transistors in the peripheral portion. The leakage current causes problems of failure of display, insufficient contrast or gradation by insufficient writing voltage. In particular, this problem is more serious in the projector which requires intense light irradiation. In the constitution of the liquid crystal display apparatus of this embodiment, when light is thrown from the top in Fig. 7, the circuit is shielded from light by metal film 715. However, the production of the photocarriers cannot be completely prevented owing to a small amount of transmitted light or diffracted light. However, in the present invention, the dense layer 708 around the transistor absorbs the photocarriers to offset the influence of the photocarrier. The layer for absorbing the photocarriers may be of a single type but may be of combination of n-type and p-type to be more effective. Further, the effect of the photocarrier absorption can be increased by application of voltage to the photocarrier-absorbing layer. In particular, the effect is more remarkable by bringing the p-layer to the lowest potential and the n-layer to the highest potential of the circuit. In this embodiment, although the transmission type of liquid crystal display apparatus is prepared by forming the peripheral circuit on a bulk silicon, and boring the displaying portion, a reflection type of liquid display apparatus can be constituted by employing a reflective metal electrode as the picture element electrode without boring the substrate. The liquid crystal material may be not only of polarization light type such as TN liquid crystals but also of a polymer dispersion type, for which the present invention is naturally effective.

According to the sixth embodiment of the present invention, a smaller, finer, and brighter liquid crystal display apparatus can be produced, which enables production of a color view finder of a video camera, a projection type of liquid display apparatus, an electronic OHP, a head-mount display, and so forth at a low cost.

### Seventh Embodiment

Application of the transistors of the present invention to memories, sensors and so forth is described. When the repetition region has, for example, the constitution shown in Figs. 4A and 4B with a dense impurity layer in the periphery thereof, the dense impurity layer forms a skeleton throughout the repetition region, whereby the potential of the well or the substrate is fixed by a low resistance, and variation of the well or the substrate is prevented.

Thereby, the advantages below are achieved:
(1) the adverse effects of flickering and noises are diminished,
(2) the adverse effects of the photocarriers are diminished, when light is thrown to a chip like a photosensor, owing to absorption of the photocarrier by the dense impurity layer in the present invention.
(3) Generally speaking, in the case that the vias is large during a MOS transistor is turned on, there is a tendency that hot carriers are generated, whereby the transistor is deteriorated and the well potential is varied, so that a malfunction of the apparatus is caused. In comparison with this, the embodiment of the present invention enables the well potential to vary hardly and has a dense layer in the peripheral area. As the result, the hot carriers are easily absorbed and accordingly the dielectric strength of the transistor is increased, whereby a higher reliability can be accomplished.

Thus the present invention provides memories, sensor chips, and the like with high operation accuracy and high reliability.

## Claims

1. A semiconductor device comprising first impurity diffusion regions for a source region and a drain region, a gate electrode, and a channel region under the gate electrode, and an insulation layer provided at least in a part of periphery of area including the channel region, the drain region, and the source region, wherein at least one of wirings for application of potential to the source region, the drain region, or the gate region passes over a second impurity diffusion region of a higher impurity concentration than the channel region of a conduction type different from the source and drain regions, and the second impurity diffusion region is placed directly underneath a thin portion of the insulation layer.

2. The semiconductor device according to claim 1, wherein the wiring for application of potential is the wiring for application of potential to the gate electrode.

3. The semiconductor device according to claim 2, wherein the wiring for application of the potential to the gate electrode has preferably a width of not more than twice the distance of the lateral diffusion of the impurity of the second impurity diffusion region.

4. The semiconductor device according to claim 2, wherein the wiring for application of potential to the gate electrode is made from an electroconductive material different from the material of the gate electrode on the portion where the wiring passes over the second impurity diffusion region.

5. The semiconductor device according to claim 1, wherein the second impurity diffusion region may be provided so as to surround the transistor constitution.

6. A liquid crystal display apparatus, employing the semiconductor device of any of claims 1 to 5.

7. A liquid crystal display apparatus, having repetition of the same pattern of regions, and having circuits for writing or reading signals, the repetition of the same pattern being constituted of semiconductor devices of any of claims 1 to 5.
